Europäisches Patentamt

European Patent Office

Office européen des brevets

(11) Veröffentlichungsnummer: **0 261 743 B1**

(12) **EUROPÄISCHE PATENTSCHRIFT**

(45) Veröffentlichungstag der Patentschrift: **03.06.92**

(21) Anmeldenummer: **87201826.2**

(22) Anmeldetag: **22.09.87**

(51) Int. Cl.⁵: **G01N 24/08**

(54) Verfahren zum Bestimmen der spektralen Verteilung der Kernmagnetisierung in einem begrenzten Volumenbereich.

(30) Priorität: **26.09.86 DE 3632738**

(43) Veröffentlichungstag der Anmeldung:
**30.03.88 Patentblatt 88/13**

(45) Bekanntmachung des Hinweises auf die Patenterteilung:
**03.06.92 Patentblatt 92/23**

(84) Benannte Vertragsstaaten:
**DE FR GB NL**

(56) Entgegenhaltungen:
**EP-A- 0 089 534
EP-A- 0 161 483
EP-A- 0 184 225
DE-A- 3 607 341
US-A- 4 318 043**

**IEEE TRANSACTIONS ON MEDICAL IMAGING, Band MI-4, Nr. 2, Juni 1985, Seiten 114-119, IEEE, New York, US; P. BENDEL: "Echo projection imaging - A method to obtain NMR images undistorted by magnetic field inhomogeneities"**

**BOOK OF ABSTRACTS: SOCIETY OF MAGNETIC RESONANCE IN MEDICINE, 5TH ANNUAL MEETING, Montreal, 19-22 August 1986, Band 3, Seiten 981-982; D.A. LAMPMAN et al.: "Improvements to volume selective 1H spectroscopy with solvent suppression"**

(73) Patentinhaber: **Philips Patentverwaltung GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB NL**

(72) Erfinder: **McKinnon, Graeme Colin, Dr.
Höschgasse 62
CH-8008 Zürich(CH)**

(74) Vertreter: **Hartmann, Heinrich, Dipl.-Ing. et al
Philips Patentverwaltung GmbH Wendenstrasse 35 Postfach 10 51 49
W-2000 Hamburg 1(DE)**

EP 0 261 743 B1

## Beschreibung

Die Erfindung betrifft ein Verfahren nach dem Oberbegriff des Anspruchs 1 sowie eine Anordnung zur Durchführung des Verfahrens.

Ein solches Verfahren ist aus dem "Book of Abstracts" der Society of Magnetic Resonanz in Medicine (Fifth annual meeting, August 19-22, 1986, Montreal, Volume 3, p. 981) bekannt.

Durch den ersten Hochfrequenzimpuls wird die Kernmagnetisierung im gesamten Untersuchungsbereich um vorzugsweise 90° gekippt. Der darauffolgende 180°-Hochfrequenzimpuls ist selektiv, d.h. während dieses Hochfrequenzimpulses ist ein magnetisches Gradientenfeld wirksam, das nur die Kernmagnetisierung in einer Schicht, deren Normale parallel zu dem Gradienten des magnetischen Gradientenfeldes verläuft, die Kernmagnetisierung um 180° kippt, während die durch den vorangehenden 90°-Hochfrequenzimpuls angeregte Kernmagnetisierung außerhalb dieser Schicht dephasiert wird. Diese Kernmagnetisierung liefert daher keinen Beitrag zu den später auftretenden Echosignalen. Der zweite 180°-Hochfrequenzimpuls ist ebenfalls selektiv, jedoch verläuft der Gradient des dabei angelegten magnetischen Gradientenfeldes senkrecht zur Richtung des während des voraufgehenden 180°-Impuls wirksamen Gradienten. Bei dem dritten 180°-Impuls einer Sequenz verläuft der Gradient des magnetischen Gradientenfeldes schließlich senkrecht zu den Gradienten während der beiden voraufgehenden 180°-Impulse.

Durch diese Sequenz wird erreicht, daß das Echosignal, das im Anschluß an die drei 180°-Hochfrequenzimpulse auftritt, nur von der Kernmagnetisierung in einem begrenzten Volumenbereich bestimmt wird. Dieses Echosignal kann einer Fourier-Transformation unterzogen werden, und das dabei enthaltene Spektrum entspricht der spektralen Verteilung der Kernmagnetisierung in dem begrenzten Volumenbereich -allerdings nur im Idealfall. In der Praxis wird das Spektrum durch zeitlich veränderliche Magnetfelder verfälscht, die durch die beim Schalten der magnetischen Gradientenfelder auftretenden Wirbelströme verursacht werden. Diese Verfälschung, die sich insbesondere in einer Verbreiterung der Linie des Spektrums äußert, ist um so ausgeprägter, je kürzer der Abstand zwischen dem letzten 180°-Hochfrequenzimpuls und dem Echosignal ist.

Bei dem bekannten Verfahren wird eine Carr-Purcell-Sequenz benutzt, bei der dieser Abstand genauso groß ist wie der Abstand des ersten Hochfrequenzimpulses vom nächsten 180°-Hochfrequenzimpuls, während die zeitlichen Abstände zwischen den drei Hochfrequenzimpulsen jeweils doppelt so groß sind wie dieser Abstand. Der Abstand zwischen dem ersten Hochfrequenzimpuls und dem Echosignal ist daher sechsmal so groß wie der Abstand zwischen dem ersten Hochfrequenzimpuls und dem nächsten 180°-Hochfrequenzimpuls. Bis zum Auftreten des Echosignals ist die Kernmagnetisierung in dem angeregten Bereich daher schon relativ stark zerfallen, so daß das Signal-Rauschverhältnis für dieses Echosignal relativ ungünstig ist. Dieses Signal-Rauschverhältnis könnte zwar dadurch verbessert werden, daß der Abstand zwischen dem ersten Hochfrequenzimpuls und dem nächsten 180°-Hochfrequenzimpuls verringert wird, jedoch würde sich dann auch der Abstand zwischen dem Echosignal und dem letzten der 180°-Hochfrequenzimpulse verringern, was eine Zunahme des Einflusses der durch die Gradientenfelder erzeugten Wirbelströme auf das Echosignal bzw. auf das daraus abgeleitete Spektrum zur Folge hätte.

Es ist Aufgabe der vorliegenden Erfindung, das Verfahren der eingangs genannten Art so auszugestalten, daß das Signal-Rauschverhältnis verbessert und/oder der Einfluß der Wirbelströme verringert werden kann.

Diese Aufgabe wird erfindungsgemäß dadurch gelöst, daß der zeitliche Abstand zwischen zwei aufeinanderfolgenden 180°-Hochfrequenzimpulsen kleiner ist als der zeitliche Abstand zwischen dem ersten Hochfrequenzimpuls und dem nächsten 180°-Hochfrequenzimpuls.

Der Erfindung liegt die Erkenntnis zugrunde, daß die beschriebene Sequenz ein einziges Echosignal auch dann liefert, wenn der Abstand zwischen den 180°-Hochfrequenzimpulsen kleiner ist als der Abstand zwischen dem ersten (nichtselektiven) Hochfrequenzimpuls der Sequenz und dem darauffolgenden selektiven 180°-Impuls - wenn nur die zeitlichen Abstände der drei 180°-Hochfrequenzimpulse voneinander gleich groß sind. Die zeitlichen Abstände zwischen dem ersten Hochfrequenzimpuls und dem nächsten darauffolgenden 180°-Impuls einerseits und zwischen jeweils zwei aufeinanderfolgenden Hochfrequenzimpulsen andererseits können dabei so gewählt werden, daß der Abstand zwischen dem ersten Hochfrequenzimpuls und dem Echosignal verringert wird (was das Signal-Rauschverhältnis verbessert) und/oder daß der zeitliche Abstand zwischen dem letzten der drei 180°-Hochfrequenzimpulse und dem Echosignal vergrößert wird (was den Einfluß der Wirbelströme auf das Echosignal verringert).

Es sei an dieser Stelle erwähnt, daß aus der US-PS 4 318 043 bereits ein Verfahren bekannt ist, das im Anschluß an einen ersten Hochfrequenzimpuls drei schichtselektive 180°-Hochfrequenzimpulse umfaßt, wobei der zeitliche Abstand zwischen zwei aufeinanderfolgenden 180°-Hochfrequenzimpulsen kleiner ist als der zeitliche Abstand zwischen dem ersten Hochfrequenzimpuls und dem nächsten 180°-Hochfrequenzimpuls. Bei diesem Verfahren beeinflussen die drei 180°-Impulse jedoch die Kernmagnetisierung in zueinander parallelen Schichten. Dadurch werden drei Spinechosignale erzeugt, die die Kernmagnetisierungsverteilung in drei parallelen langgestreckten Bereichen darstellen und deren zeitlicher Abstand vom zugehörigen 180°-Hochfrequenzimpuls genauso groß ist wie dessen Abstand vom ersten 90°-Impuls.

Der Einfluß der Wirbelströme auf die für den angeregten Volumenbereich ermittelte spektrale Verteilung der Kernmagnetisierung läßt sich noch weiter dadurch verringern, daß die Sequenz nach einer Weiterbildung der Erfindung mehrmals durchgeführt wird, wobei von Sequenz zu Sequenz der zeitliche Abstand zwischen dem ersten Hochfrequenzimpuls und dem nächsten 180°-Hochfrequenzimpuls variiert wird, während der zeitliche Abstand zwischen den 180°-Hochfrequenzimpulsen in allen Sequenzen konstant gehalten wird und daß aus den Abtastwerten der Echosignale jeweils diejenigen einer Fourier-Transformation unterworfen werden, die innerhalb der Sequenz den gleichen Abstand zu einem der drei 180°-Hochfrequenzimpulse aufweisen.

Bei dieser Weiterbildung werden also nicht die Abtastwerte eines einzigen Echosignals einer Fourier-Transformation unterzogen, sondern die aus den Echosignalen verschiedener Sequenzen abgeleiteten Abtastwerte, die jeweils den gleichen Abstand von jedem der drei 180°-Hochfrequenzimpulse und damit die gleiche zeitliche Lage in bezug auf jedes der drei magnetischen Gradientenfelder aufweisen. Es läßt sich zeigen, daß das durch die Fourier-Transformation eines Echosignals erhaltene Frequenzspektrum dem Frequenzspektrum entspricht, das sich ergeben würde, wenn der störende Einfluß der Wirbelströme nicht vorhanden wäre, wobei die einzelnen Spektralwerte mit einem Faktor multipliziert sind, der u.a. davon abhängt, wie lange die Wirbelströme in der betreffenden Sequenz auf die Kernmagnetisierung eingewirkt haben. Diese Störeinflüsse werden dann ganz ausgeschaltet, wenn die Fourier-Transformation aufgrund derjenigen Abtastwerte aus verschiedenen Sequenzen erfolgt, die jeweils denselben Störeinfluß durch die Wirbelströme erfahren haben. Gerade dies ist bei der Erfindung der Fall.

Es sei an dieser Stelle erwähnt, daß in der deutschen Patentanmeldung P 36 07 341.5 schon ein ähnliches Verfahren beschrieben ist. Die dabei angegebenen Sequenzen enthalten jedoch entweder nur zwei Hochfrequenzimpulse nach Art eines Spin-Echoverfahrens oder nur drei Hochfrequenzimpulse zur Erzeugung von stimulierten Echosignalen. Wie in dieser Patentanmeldung ausgeführt ist, können die zur Fourier-Transformation herangezogenen Abtastwerte nicht von allen während des voraufgegangenen Teil der Sequenz ein- und ausgeschalteten magnetischen Gradientenfeldern den gleichen zeitlichen Abstand, so daß dabei eine Reststörung durch Wirbelströme verbleibt - im Gegensatz zur vorliegenden Erfindung.

Eine Anordnung zur Durchführung des Verfahrens ist versehen mit einem Magneten zur Erzeugung eines homogenen stationären Magnetfeldes, einer Hochfrequenz-Spulenanordnung zur Erzeugung eines hochfrequenzten, zum stationären Magnetfeld senkrechten Magnetfeldes, einem Hochfrequenzgenerator zur Speisung der Hochfrequenz-Spulenanordnung, Mitteln zum Erzeugen von magnetischen Gradientenfeldern, einer Steuereinheit zur Steuerung des Hochfrequenzgenerators und der Mittel, und mit einer Recheneinheit zur Verarbeitung von Kernspin-Resonanzsignalen und ist dadurch gekennzeichnet, daß die Steuereinheit so ausgebildet ist, daß in jeder Sequenz ein erster Hochfrequenzimpuls erzeugt wird und danach drei weitere 180°-Hochfrequenzimpulse, wobei die Mittel so geschaltet werden, daß während jedes dieser drei 180°-Hochfrequenzimpulse der Gradient des Magnetfeldes in einer anderen Richtung verläuft, und daß die Recheneinheit so ausgebildet ist, daß sie eine Fourier-Transformation mit den Abtastwerten der Echosignale durchführt.

Die Erfindung wird nachstehend anhand der Zeichnungen näher erläutert. Es zeigen

Fig. 1     ein Gerät für medizinische Kernspinuntersuchungen, mit dem das erfindungsgemäße Verfahren durchführbar ist,

Fig. 2     ein Blockschaltbild eines solchen Gerätes,

Fig. 3     den zeitlichen Verlauf verschiedener Signale bei dem erfindungsgemäßen Verfahren.

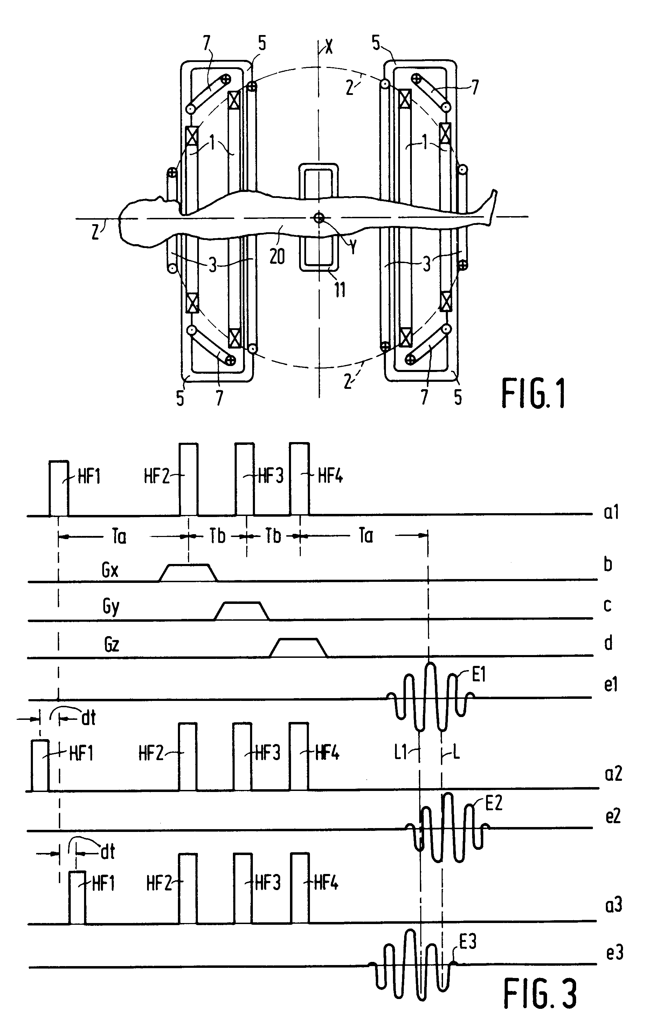

Das in Fig. 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sich vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gadientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. - Im Anschluß an drei Hochfrequenzimpulse dient die Hochfrequenzspule 11 zum Empfangen des im Untersuchungsbereich erzeugten Echosignals. Statt dessen kann aber auch eine gesonderte Hochfrequenz-Empfangsspule verwendet werden.

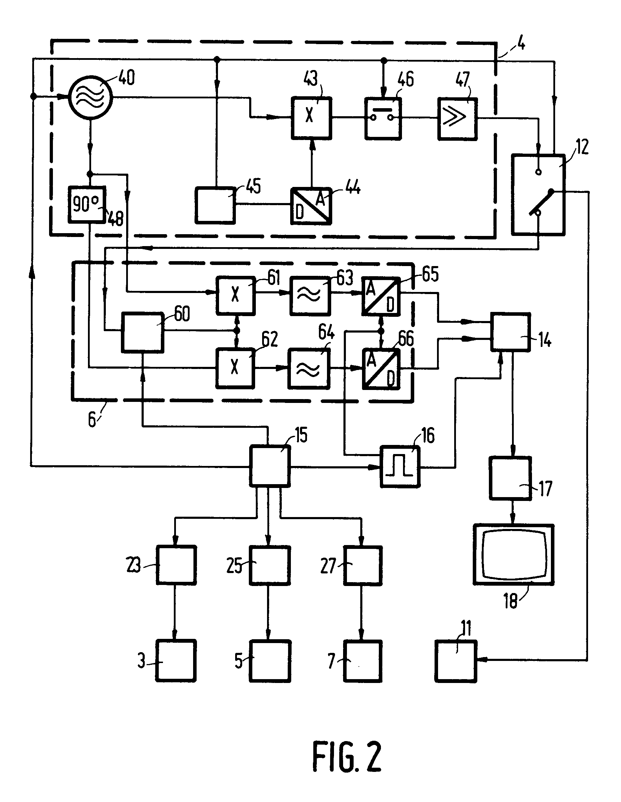

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz der anzuregenden Atomkerne bei der von den Spulen 1 erzeugten Feldstärke liefert. Die Larmorfrequenz f berechnet sich bekanntlich nach der Beziehung $f = cB$, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte stimulierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner zugeführt, der daraus durch eine diskrete Fourier-Transformation die spektrale Verteilung der Kernmagnetisierung ermittelt und an einer geeigneten Wiedergabeeinheit, z.B. einem Monitor 18, ausgibt.

In Fig. 3 ist der zeitliche Verlauf von verschiedenen mit der Schaltung nach Fig. 2 empfangenen oder erzeugten Signalen für das erfindungsgemäße Verfahren dargestellt. Die erste Zeile al zeigt den zeitlichen Verlauf des Ausgangssignals des Hochfrequenzerzeugers 4 bei einer (ersten) Sequenz. Die Sequenz umfaßt einen ersten Hochfrequenzimpuls HF1, der vorzugsweise ein 90°-Impuls ist, d.h. durch ihn wird die Kernmagnetisierung im Untersuchungsbereich um 90° gegenüber der Richtung des homogenen stationären Magnetfeldes gekippt. Um den Zeitraum Ta später folgt ein 180°-Impuls HF2, dem nach einem Zeitraum Tb ein weiterer 180°-Impuls HF3 folgt, wonach -wiederum um den Zeitraum Tb später - ein dritter 180°-Impuls HF4 folgt.

Bei dem eingangs erwähnten bekannten Verfahren ist der Zeitraum Tb jeweils doppelt so groß wie der Zeitraum Ta. Dabei wird das durch den 180°-Impuls HF2 erzeugte und zum Zeitpunkt Ta nach dieser Hochfrequenz auftretende erste Echosignal durch den darauffolgenden 180°-Impuls HF3 "gespiegelt", so daß zur Zeit Ta nach dem Hochfrequenzimpuls HF3 ein weiteres Echosignal auftritt, das seinerseits wieder durch den darauffolgenden 180°-Impuls gespiegelt wird und ein drittes Echosignal zur Folge hat. Dieses Verfahren könnte mittels eines vierten und gegebenenfalls weitere 180°-Impulse, die den vorangehenden Impulsen jeweils im Abstand von 2 Ta folgen, wiederholt werden. - Demgegenüber ist bei der Erfindung der zeitliche Abstand Tb zwischen den 180°-Hochfrequenzimpulsen HF2 und HF3 bzw. HF3 und HF4 kleiner als der zeitliche Abstand Ta zwischen dem 90°-Hochfrequenzimpuls HFl und dem nächsten 180°-Impuls HF2. Die Wirkung der erfindungsgemäßen Sequenz läßt sich folgendermaßen erklären: Unter dem Einfluß der unvermeidlichen Inhomogenitäten des durch die Spulenanordnung erzeugten stationären Magnetfeldes dephasiert die Kernmagnetisierung nach dem 90°-Hochfrequenzimpuls in dem durch diesen Impuls angeregten Bereich. Dadurch nimmt die Amplitude des im Anschluß an diesen Hochfrequenzimpuls im Untersuchungsbereich erzeugten Kernspin-Resonanzsignals, des sogenannten FID-Signals, relativ schnell ab. Der darauffolgende 180°-Impuls HF2 bewirkt bekanntlich, daß die Dephasierung in eine Rephasierung umgekehrt wird, die -wenn nicht noch weitere Hochfrequenzimpulse folgen würden - zur Zeit Ta nach dem 180°-Impuls HF2 ein Spin-Echosignal erzeugen würde. Dazu kommt es jedoch nicht, weil im zeitlichen Abstand Tb nach dem 180°-Hochfrequenzimpuls HF2 schon der weitere 180°-Hochfrequenzimpuls HF3 auftritt. Dieser 180°-Impuls beendet die Rephasierung und bewirkt eine Wiederaufnahme der Dephasierung bis im zeitlichen Abstand Tb von diesem 180°-Impuls der dritte 180°-Hochfrequenzimpuls HF4 auftritt, der die Dephasierung beendet und eine Rephasierung einleitet. Da der Zeitraum der Dephasierung nach dem 180°-Hochfrequenzimpuls HF3 genauso lang ist wie der Zeitraum der Rephasierung nach dem Hochfrequenzfrequenzimpuls HF2, hebt sich die Wirkung der beiden 180°-Impulse HF2 und HF3 zum Zeitpunk des Auftretendes des Hochfrequenzimpulses HF4 gerade auf, so daß sich die Kernmagnetisierung während des dritten 180°-Hochfrequenzimpulses im gleichen Zustand befindet, wie während des zweiten 180°-Hochfrequenzimpulses (wenn man einmal von dem T2-Zerfall absieht). Infolgedessen ist die nach dem 90°-Hochfrequenzimpuls HF1 als Folge der Inhomogenität des stationären Magnetfeldes einsetzende Dephasierung im zeitlichen Abstand Ta vom dritten 180°-Hochfrequenzimpuls HF4 beseitigt, so daß zu diesem Zeitpunkt ein (Spin-) Echosignal E1 auftritt (vgl. Zeile e1).

Bei jedem der drei 180°-Impulse wird eine der drei Gradientenspulenanordnungen 3, 5 und 7 ein- und ausgeschaltet. Das Ein- und Ausschalten erfolgt jeweils vor bzw. nach dem zugeordneten Hochfrequenzimpuls, so daß der zeitliche Verlauf des magnetischen Gradientenfeldes symmetrisch zum zeitlichen Verlauf des zugeordneten Hochfrequenzimpulses liegt. Gemäß Zeile b wird während des ersten 180°-Hochfrequenzimpulses HF2 der Stromgenerator 27 eingeschaltet, so daß die Spulenanordnung 7 ein magnetisches Gradientenfeld Gx mit einem in x-Richtung verlaufenden Gradienten erzeugt. In ähnlicher Weise ist der zweite Hochfrequenzimpuls HF3 von dem magnetischen Gradientenfeld Gy und der dritte Hochfrequenzimpuls HF4 von dem magnetischen Gradientenfeld Gz begleitet (vgl. Zeilen c und d).

Somit ist der 90°-Hochfrequenzimpuls ein nichtselektiver Impuls, weil während dieses Impulses kein magnetisches Gradientenfeld wirksam ist und sind die 180°-Impulse HF2, HF3 und HF4 schichtselektive Impulse, die die Kernmagnetisierung in drei zueinander senkrechten Schichten anregen und die die außerhalb dieser Schichten durch die vorangegangenen Hochfrequenzimpulse der Sequenz angeregte Kernmagnetisierung dephasieren. Infolgedessen hängt das Echosignal E1 im wesentlichen nur von der Kernmagnetisierung in einem begrenzten Volumenbereich ab, der durch den Schnittbereich der drei Schichten bestimmt wird. Dieses Echosignal kann in bekannter Weise einer Fourier-Transformation unterzogen werden, woraus sich das Spektrum der in dem begrenzten Volumenbereich angeregten Kernmagnetisierung ergibt.

Wie bereits erwähnt, wird der zeitliche Verlauf des Echosignals E1 (und damit auch der Verlauf des daraus durch Fourier-Transformation berechneten Spektrums) durch die zeitlich veränderlichen Magnetfelder verfälscht, die durch die beim Schalten der magnetischen Gradientenfelder Gx, Gy und Gz auftretenden Wirbelströme verursacht werden. Der Einfluß dieser Wirbelströme läßt sich zwar dadurch verringern, daß der Abstand Ta zwischen dem 90°-Hochfrequenzimpuls HF1 und dem 180°-Hochfrequenzimpuls HF2 vergrößert wird, weil sich dann der zeitliche Abstand des Echosignals E1 vom dritten 180°-Hochfrequenzimpuls HF4 entsprechend vergrößert und die Wirbelströme dann schon stärker abgeklungen sind, doch nimmt die Amplitude des Echosignals E1 dabei aufgrund des unvermeidlichen T2-Zerfalls ab.

Um den Störeinfluß der Wirbelströme auf das durch Fourier-Transformation ermittelte Spektrum der Kernmagnetisierung vollständig zu beseitigen, wird die beschriebene Sequenz wiederholt, wobei lediglich der Abstand zwischen dem 90°-Hochfrequenzimpuls HF1 und dem darauffolgenden 180°-Hochfrequenzimpuls HF2 um den Zeitraum dt variiert wird, während der zeitliche Abstand der Hochfrequenzimpulse HF2, HF3 und HF4 untereinander unverändert bleibt ebenso wie die zeitliche Lage der magnetischen Gradientenfelder Gx, Gy und Gz in bezug auf diese Impulse. Der zeitliche Verlauf der magnetischen Gradientenfelder ist daher nicht noch einmal dargestellt; dagegen zeigt die Zeile a2 den zeitlichen Verlauf der Hochfrequenzimpulse bei einem um dt vergrößerten zeitlichen Abstand zwischen HF1 und HF2, während die Zeile a3 diesen zeitlichen Verlauf für einen um dt verringerten Abstand zeigt. Infolge der Vergrößerung bzw. der Verkleinerung des Abstandes zwischen HF1 und HF2 wird auch der Abstand zwischen dem letzten 180°-Impuls HF4 und dem Echosignal vergrößert (vgl. E2 in Zeile e2) bzw. verkleinert.

Der Taktgenerator 16 wird durch ein Steuersignal der Steuereinheit 15 so gesteuert, daß er nur während des Auftretens der Echosignale E1...E3 freigegeben ist. Dabei werden die Ausgangssignale der Tiefpässe 63 und 64 (das sind die Real- und Imaginärteile der Echosignale E1, E2 und E3) in digitale Abtastwerte umgesetzt und in dem Speicher 14 gespeichert.

Der Rechner 17 ist so programmiert, daß er die Abtastwerte in den einzelnen Sequenzen, die jeweils im gleichen zeitlichen Abstand vom 180°-Hochfrequenzimpuls HF4 auftreten -z.B. die in Fig. 3 durch die Linie L verbundenen Abtastwerte - einer Fourier-Transformation unterzieht, nachdem diese in aufsteigender oder absteigender Folge entsprechend dem zeitlichen Abstand zwischen dem ersten Hochfrequenzimpuls HF1 und dem nächsten 180°-Impuls HF2 geordnet worden sind (bei dem Beispiel gemäß Fig. 3 also entweder E3-E1-E2 oder E2-E1-E3). Hierbei wird also nicht die Folge der Abtastwerte eines einzigen Echosignals einer Fourier-Transformation unterzogen, sondern diejenigen Abtastwerte verschiedener Echosignale, bei denen der Störeinfluß der Wirbelströme jeweils während des gleichen Zeitraums innerhalb einer Sequenz wirksam war. Es läßt sich zeigen, daß das durch eine derartige Fourier-Transformation erhaltene Frequenzspektrum dem Frequenzspektrum entspricht, das sich bei der Fourier-Transformation eines einzelnen, mit dem zeitlichen Abstand dt abgetasteten Echosignals ergeben würde, wenn die Wirbelströme nicht vorhanden wären.

Wenn man von den einzelnen Echosignalen einen jeweils zu einem anderen Zeitpunkt - z.B. zu dem durch die strichpunktierte Linie L1 bestimmten Zeitpunkt - auftretenden Abtastwert einer Fourier-Transformation unterziehen würde, dann müßte sich im Idealfall das gleiche Frequenzspektrum ergeben. Aufgrund unvermeidlicher Fehler bei der Meßwerterfassung und Verarbeitung ergeben sich jedoch Abweichungen, die dadurch verringert werden können, daß mehrere Folgen von Abtastwerten der Fourier-Transformation unterzogen werden, wobei jede Folge nur solche Abtastwerte umfaßt, die den gleichen zeitlichen Abstand vom Hochfrequenzimpuls haben und daß die auf diese Weise erhaltenen, geringfügig voneinander abweichenden Frequenzspektren addiert werden.

Wenn eine Fourier-Transformation mit nur drei Stützstellen ausgeführt wird, wie in dem in Fig. 3 dargestellten Ausführungsbeispiel, ergibt sich nur eine sehr grobe spektrale Auflösung. Für eine verbesserte Auflösung sind wesentlich mehr Stützstellen und damit eine entsprechend höhere Anzahl von Sequenzen erforderlich.

**Patentansprüche**

1. Verfahren zum Bestimmen der spektralen Verteilung der Kernmagnetisierung in einem begrenzten Volumenbereich, bei dem in Anwesenheit eines homogenen stationären Magnetfeldes auf einen Untersuchungsbereich wenigstens eine Sequenz einwirkt, die einen ersten Hochfrequenzimpuls und danach drei im gleichen zeitlichen Abstand aufeinanderfolgende, schichtselektive 180°-Hochfrequenzimpulse umfaßt, die die Kernmagnetisierung in drei zueinander senkrechten Schichten beeinflussen, wobei jeweils das im Schnittbereich der drei Schichten im Anschluß an den letzten 180°-Impuls erzeugte Echosignal in digitale Abtastwerte umgesetzt wird, wonach eine Fouriertransformation durchgeführt wird, dadurch gekennzeichnet, daß der zeitliche Abstand (Tb) zwischen zwei aufeinanderfolgenden 180°-Hochfrequenzimpulsen kleiner ist als der zeitliche Abstand (Ta) zwischen dem ersten Hochfrequenzimpuls und dem nächsten 180°-Hochfrequenzimpuls.

2. Verfahren nach Anspruch 1,
dadurch gekennzeichnet, daß die Sequenz mehrmals durchgeführt wird, wobei von Sequenz zu Sequenz der zeitliche Abstand zwischen dem ersten Hochfrequenzimpuls (HF1) und dem nächsten 180°-Hochfrequenzimpuls (HF2) variiert wird, während der zeitliche Abstand zwischen den Hochfrequenzimpulsen (HF2-HF3-HF4) in allen Sequenzen konstant gehalten wird und daß aus den Abtastwerten der Echosignale (E1, E2, E3) jeweils diejenigen einer Fourier-Transformation unterworfen werden, die innerhalb der Sequenz den gleichen Abstand zu einem der drei 180°-Hochfrequenzimpulse aufweisen (Geraden L oder L1).

3. Verfahren nach Anspruch 2,
dadurch gekennzeichnet, daß mehrere Folgen von Abtastwerten einer Fourier-Transformation unterzogen werden, wobei die Abtastwerte einer Folge jeweils den gleichen zeitlichen Abstand von einen der drei 180°-Hochfrequenzimpulse der jeweiligen Sequenz aufweisen, daß die daraus resultierenden spektralen Verteilungen addiert werden.

4. Anordnung zur Durchführung des Verfahrens nach Anspruch 1 mit einem Magneten (1) zur Erzeugung eines homogenen stationären Magnetfeldes, einer Hochfrequenz-Spulenanordnung (11) zur Erzeugung eines hochfrequenten, zum stationären Magnetfeld senkrechten Magnetfeldes, einem Hochfrequenzgenerator (4) zur Speisung der Hochfrequenz-Spulenanordnung (11), Mitteln (3,5,7;23,25,27) zum Erzeugen von magnetischen Gradientenfeldern, einer Steuereinheit (15) zur Steuerung des Hochfrequenzgenerators und der Mittel (3,5,7;23,25,27), und mit einer Recheneinheit zur Verarbeitung von Kernspin-Resonanzsignalen,
dadurch gekennzeichnet, daß die Steuereinheit (15) so ausgebildet ist, daß in jeder Sequenz ein erster Hochfrequenzimpuls erzeugt wird und danach drei weitere 180°-Hochfrequenzimpulse, wobei die Mittel (3,5,7;23,25,27) so geschaltet werden, daß während jedes dieser drei 180°-Hochfrequenzimpulse der Gradient des Magnetfeldes in einer anderen Richtung verläuft, und daß die Recheneinheit so ausgebildet ist, daß sie eine Fourier-Transformation mit den Abtastwerten der Echosignale durchführt.

5. Anordnung nach Anspruch 4,

dadurch gekennzeichnet, daß die Steuereinheit (15) so ausgebildet ist, daß der Abstand zwischen dem ersten Hochfrequenzimpuls und dem darauffolgenden 180°-Impuls von Sequenz zu Sequenz veränderbar ist, und daß die Recheneinheit so ausgeführt ist, daß sie eine Fourier-Transformation mit denjenigen Abtastwerten der Echosignale aus aufeinanderfolgenden Sequenzen durchführt, die jeweils den gleichen zeitlichen Abstand von einem der 180°-Impulse aufweisen.

## Claims

1. A method of determining the spectral distribution of the nuclear magnetization in a limited volume part, in which at least one sequence acts on an examination zone in the presence of a uniform, steady magnetic field, which sequence comprises a first high-frequency pulse and subsequently three slice-selective 180° high-frequency pulses which succeed one another at the same distance in time and which influence the nuclear magnetization in three mutually perpendicular slices, the echo signal produced at the area of intersection of the three slices after the last 180° pulse being each time converted into digital sample values, after which a Fourier-transformation is carried out, characterized in that the distance in time (Tb) between two successive 180° high-frequency pulses is smaller than the distance in time (Ta) between the first high-frequency pulse and the next 180° high-frequency pulse.

2. A method as claimed in Claim 1, characterized in that the sequence is carried out several times, the distance in time between the first high-frequency pulse (HF1) and the next 180° high-frequency pulse (HF2) being varied from sequence to sequence, whereas the distance in time between the high-frequency pulses (HF2-HF3-HF4) in all sequences is kept constant, and in that each time those sample values of the echo signals (E1, E2, E3) which, within the sequence, have the same distance from one of the three 180° high-frequency pulses (straight lines L or L1) are subjected to a Fourier-transformation.

3. A method as claimed in Claim 2, characterized in that several sequences of sample values are subjected to a Fourier-transformation, the sample values of a sequence each time having the same distance in time from one of the three 180° high-frequency pulses of the respective sequence, and in that the spectral distributions resulting therefrom are added to each other.

4. A device for carrying out the method claimed in Claim 1, comprising a magnet (1) for generating a uniform, steady magnetic field, a high-frequency coil system (11) for generating a high-frequency magnetic field perpendicularly to the steady magnetic field, a high-frequency generator (4) for feeding the high-frequency coil system (11), means (3,5,7;23,25,27) and an arithmetic unit for processing nuclear-spin resonance signals, characterized in that the control unit (15) is constructed so that in each sequence a first high-frequency pulse is generated and subsequently three further 180° high-frequency pulses are generated, the means (3,5,7;23,25,27) being switched so that during each of said three 180° high-frequency pulses the gradient of the magnetic field extends in a different direction, and the arithmetic unit being constructed so that it carries out a Fourier-transformation with the sample values of the echo signals.

5. A device as claimed in Claim 4, characterized in that the control unit (15) is constructed so that the distance between the first high-frequency pulse and the subsequent 180° pulse can be varied from sequence to sequence, and in that the arithmetic unit is constructed so that it carries out a Fourier-transformation with those sample values of the echo signals from successive sequences which each time have the same distance in time from one of the 180° pulses.

**Revendications**

1. Procédé pour déterminer la distribution spectrale de la magnétisation nucléaire dans un domaine volumique limité, dans lequel, en présence d'un champ magnétique statique homogène, agit sur un domaine d'examen, au moins une séquence qui comprend une première impulsion de haute fréquence suivie de trois impulsions de haute fréquence à 180° à sélectivité de couche se succèdant avec le même espacement temporel, qui influencent la magnétisation nucléaire dans trois couches perpendiculaires l'une à l'autre, le signal d'écho produit dans le domaine de coupe des trois couches suite à la dernière impulsion à 180° étant chaque fois converti en valeurs d'échantillonnage numériques, après quoi une transformation de Fourier est effectuée, caractérisé en ce que l'espacement temporel (Tb) de deux impulsions de haute fréquence à 180° successives est inférieur à l'espacement temporel (Ta) de la première impulsion de haute fréquence et de l'impulsion de haute fréquence à 180° suivante.

2. Procédé suivant la revendication 1, caractérisé en ce que la séquence est exécutée à plusieurs reprises, en faisant varier, d'une séquence à l'autre, l'espacement temporel de la première impulsion de haute fréquence (HF1) et de l'impulsion de haute fréquence à 180° (HF2) suivante, tandis qu'on maintient l'espacement temporel des impulsions de haute fréquence (HF2-HF3-HF4) constant dans toutes les séquences et que, parmi les valeurs d'échantillonnage des signaux d'écho (E1, E2, E3), on soumet chaque fois à une transformation de Fourier celles qui, à l'intérieur de la séquence, présentent le même espacement par rapport à l'une des trois impulsions de haute fréquence à 180° (lignes L ou L1).

3. Procédé suivant la revendication 2, caractérisé en ce que plusieurs successions de valeurs d'échantillonnage sont soumises à une transformation de Fourier, les valeurs d'échantillonnage d'une succession présentant chaque fois le même espacement temporel par rapport à l'une des trois impulsions de haute fréquence à 180° de la séquence en question, et que les distributions spectrales qui en résultent sont additionnées.

4. Montage pour l'exécution du procédé suivant la revendication 1, comportant un aimant (1) destiné à produire un champ magnétique statique homogène, un montage de bobine haute fréquence (11) destiné à produire un champ magnétique de haute fréquence perpendiculaire au champ magnétique statique, un générateur de haute fréquence (4) destiné à alimenter le montage de bobines haute fréquence (11), des moyens (3, 5, 7; 23, 25, 27) pour produire des champs de gradients magnétiques, une unité de commande (15) pour commander le générateur de haute fréquence et les moyens (3, 5, 7; 23, 25, 27) et une unité de calcul destinée à traiter les signaux de résonance magnétique nucléaire, caractérisé en ce que l'unité de commande (15) est conçue de façon telle que, dans chaque séquence, soit produite une première impulsion de haute fréquence, suivie de trois autres impulsions de haute fréquence à 180°, les moyens (3, 5, 7; 23, 25, 27) étant connectés de façon que pendant chacune de ces trois impulsions de haute fréquence à 180°, le gradient du champ magnétique s'étende dans une autre direction, et que l'unité de calcul est conçue de façon qu'elle effectue une transmission de Fourier avec les valeurs d'échantillonnage des signaux d'écho.

5. Montage suivant la revendication 4, caractérisé en ce que l'unité de commande (15) est conçue de façon telle que l'espacement de la première impulsion de haute fréquence et de l'impulsion à 180° suivante puisse être modifié d'une séquence à l'autre et que l'unité de calcul est agencée d'une manière telle qu'elle effectue une transformation de Fourier avec les valeurs d'échantillonnage des signaux d'écho provenant de séquences successives, qui présentent chaque fois le même espacement temporel par rapport à l'une des impulsions à 180°.

FIG.1

FIG.3

FIG. 2